Europäisches Patentamt

European Patent Office

Office européen des brevets

(19)

(11) Veröffentlichungsnummer: **0 188 699**
**B1**

(12) **EUROPÄISCHE PATENTSCHRIFT**

(45) Veröffentlichungstag der Patentschrift: **05.09.90**

(51) Int. Cl.5: **H 03 K 17/94,** H 01 H 61/013

(21) Anmeldenummer: **85115014.4**

(22) Anmeldetag: **27.11.85**

(54) **Anordnung zum Ankoppeln von Betätigungsvorrichtungen an elektronische Näherungsschalter hierfür.**

(30) Priorität: **11.12.84 DE 3445158**

(43) Veröffentlichungstag der Anmeldung:
**30.07.86 Patentblatt 86/31**

(45) Bekanntmachung des Hinweises auf die
Patenterteilung:
**05.09.90 Patentblatt 90/36**

(84) Benannte Vertragsstaaten:
**AT CH DE FR GB IT LI**

(56) Entgegenhaltungen:
**EP-A-2 520 123**
**DE-A-2 537 541**
**DE-A-3 234 763**
**US-A-3 489 976**
**US-A-4 337 450**

**ELEKTOR, Band 3, Nr. 7/8, Juli/August 1977,
Seite 26, Canterbury, GB; "Thermal touch
switch"**

(73) Patentinhaber: **Siemens Aktiengesellschaft
Wittelsbacherplatz 2
D-8000 München 2 (DE)**

(72) Erfinder: **Wimmer, Gerhard
Lindenstrasse 25
D-8411 Waldetzenberg (DE)**

EP 0 188 699 B1

**Beschreibung**

Die Erfindung bezieht sich auf Näherungsschalter, die auf thermische Veränderungen in einem von außerhalb des Schalters strahlungszugänglich Erfassungsfeld ansprechen.

Üblicherweise haben elektronische Näherungsschalter für die Fernbedienung zumindest einen Nebenstelleneingang, an dem Betätigungsvorrichtungen angeschlossen werden können. Bei verschiedenartigen Anwendungsgebieten, wie beispielsweise in der Installationstechnik, ist es erwünscht, Betätigungsvorrichtungen mit Glimmlampen zu verwenden, um den Bedienungskomfort bei schlechten Sichtverhältnissen zu erhöhen. In derartigen Betätigungsvorrichtungen ist die Glimmlampe parallel zur Schaltstrecke der Betätigungsvorrichtung angeordnet, deren einer Pol an Phase liegt und deren anderer Pol zum Betrieb der Glimmlampe an einer anderen Phase oder an Nullpotential anzuschließen ist. Bei elektronischen Näherungsschalter ist es in der Praxis aufwendig oder schwierig, für den zweiten Pol der Glimmlampe ein geeignetes Potential zur Verfügung zu stellen. Geeignete praktische Lösungen sind nicht auf dem Markt.

Der Erfindung liegt die Aufgabe zugrunde, eine Anordnung zum Ankoppeln von Betätigungsvorrichtungen an elektronische Näherungsschalter gemäß dem Oberbegriff des Patentanspruchs zu entwickeln, die es gestattet, auch Betätigungsvorrichtungen mit Glimmlampen einzusetzen.

Die Lösung der geschilderten Aufgabe besteht darin, daß am Erfassungsfeld ein elektrischer Widerstand angeordnet ist, der in den Stromkreis der Betätigungsvorrichtung eingeschaltet ist.

Bei einer Betätigungsvorrichtung mit Glimmlampe liegt dadurch außer der Betriebsspannung, der Phase, das zweite Betriebspotential, in der Regel Nullpotential, am anderen Pol der Glimmlampe im ausgeschalteten Zustand an. Dadurch liegt an der Glimmlampe sicher die für sie erforderliche Betriebsspannung im ausgeschalteten Zustand an, so daß die Funktion der Glimmlampe gewährleistet ist.

Bei einem Näherungsschalter mit Nebenstelleneingang zum Anschließen einer Betätigungsvorrichtung kann zwischen dem Nebenstelleneingang und dem Nullpotential der elektrische Widerstand am Erfassungsfeld angeordnet sein. Ein derartiger Näherungsschalter kann Betätigungsvorrichtungen mit Glimmlampen sinnvoll nutzen.

Die Erfindung soll nun anhand von in der Zeichnung grob schematisch wiedergegebenen Ausführungsbeispielen näher erläutert werden:

In Fig. 1 ist eine Anordnung zum Ankoppeln von Betätigungsvorrichtungen an elektronische Näherungsschalter die auf thermische Veränderungen an einem Erfassungsfeld ansprechen, veranschaulicht.

In Fig. 2 ist ein Näherungsschalter mit Nebenstelleneingang wiedergegeben, der von einer Betätigungsvorrichtung mit Glimmlampe in Fernbedienung geschaltet werden kann.

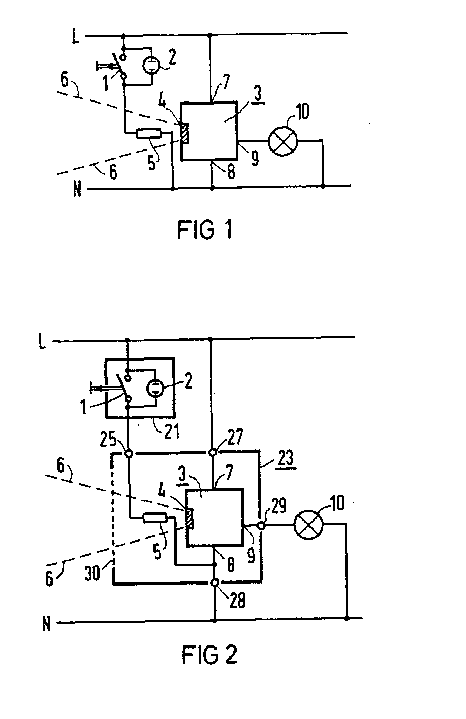

In der Anordnung nach Fig. 1 wird die Betriebsspannung über einen Außenleiter L für phase und einen Neutralleiter N, in der Praxis wohl der geerdete Neutralleiter, also der Nulleiter, zugeführt. Eine Betätigungsvorrichtung 1 ist als Taster veranschaulicht, zu dessen Schaltstrecke eine Glimmlampe 2 parallel geschaltet ist. Ein elektronisches Gerät 3 weist ein Erfassungsfeld 4 auf, durch das es auf thermische Veränderungen anspricht. Am Erfassungsfeld 4 ist ein elektrischer Widerstand 5 angeordnet, der im Stromkreis der Betätigungsvorrichtung 1 eingeschaltet ist. Vom Erfassungsfeld 4 werden thermische Veränderungen in einem räumlichen Erfassungsbereich 6 bemerkt.

Dem elektronischen Gerät 3 wird die Betriebsspannung über Anschlüsse 7 und 8 zugeführt; ein Verbraucher 10 kann am Ausgang 9 angeschlossen werden. Im Ausführungsbeispiel ist der Verbraucher 10 als Lampe veranschaulicht.

Solange die Schaltstrecke der Betätigungsvorrichtung 1 geöffnet ist, liegt über den elektrischen Widerstand 5 an der Glimmlampe 2 Nullpotential vom Neutralleiter N an. Zusammen mit der Phase über den Außenleiter L wird der Glimmlampe 2 daher eine ausreichende Betriebsspannung zugeführt. Wenn die Schaltstrecke der Betätigungsvorrichtung 1 geschlossen ist, erlischt die Glimmlampe, da ihre Betriebsspannung so lange kurzgeschlossen ist. Die Unterbrechung der Glimmlampe kann in gewohnter Weise auch als Signalgabe verstanden werden.

In der Anordnung nach Fig. 2 ist ein Näherungsschalter 23 dargestellt, der ein elektronisches Gerät 3 und einen elektrischen Widerstand 5 am Erfassungsfeld 4 bzw. in dessen Erfassungsbereich 6 aufweist. Die Versorgungsspannung wird dem Näherungsschalter 23 über die Anschlüsse 27 und 28 zugeführt. Verbraucher 10 können am Verbraucherausgang 29 angeschlossen werden. Am Nebenstelleneingang 25 kann eine Betätigungsvorrichtung 21 mit Glimmlampe angeschlossen werden. Zwischen dem Nebenstelleneingang 25 und einem Anschluß an Nullpotential ist der elektrische Widerstand 5 eingeschaltet. Der Näherungsschalter 23 weist vor seinem Erfassungsfeld 4 ein für thermische Strahlung durchlässiges Fenster 30 auf.

Wenn der Näherungsschalter 23 an seinem Erfassungsfeld 4 eine thermische Veränderung bemerkt, löst das einen Schaltvorgang aus, so daß ein am Ausgang 29 angeschlossenes Gerät, im Ausführungsbeispiel eine Leuchte bzw. eine Lampe 10 eingeschaltet wird. Eine derartige thermische Veränderung bewirkt beispielsweise eine sich dem Näherungsschalter annähernde Person in einem Raum.

Andererseits kann man auch aus der Ferne über die Betätigungsvorrichtung 21 den am Ausgang 29 angeschlossenen Verbraucher einschalten. Bei geschlossener Kontaktstrecke einer Betätigungsvorrichtung 21 wird hierbei über den Widerstand 5 ein Strom zur zweiten Anschlußleitung, zum Neutralleiter N geführt, der den Widerstand 5 erwärmt, was über das Erfassungsfeld 4 gleichfalls einen Schaltvorgang auslöst. Zweckmäßigerweise ist der Widerstand 5 im Näherungsschalter 23 intern am Nullpotential über den externen Anschluß 28 bzw. über den inneren Anschluß 8 angeschlossen.

**Patentanspruch**

Näherungsschalter (23), der auf thermische Veränderungen in einem von außerhalb des Schalters strahlungszugänglichen Erfassungsfeld (4) anspricht und einen Nebenstelleneingang (25) zum Anschließen einer Betätigungsvorrichtung (21) aufweist, dadurch gekennzeichnet, daß zwischen dem Nebenstelleneingang (25) und dem Nullpotential ein elektrischer Widerstand (5) am Erfassungsfeld (4) so angeordnet ist, daß der Näherungsschalter auf andere thermische Veränderungen im Erfassungsfeld weiterhin anspricht.

**Revendication**

Interrupteur de proximité (23), qui répond à des variations thermiques d'un panneau de détection (4) accessible pour le rayonnement à partir de l'extérieur de l'interrupteur et comporte une entrée additionnelle (25) prévue pour le raccordement d'un dispositif d'actionnement (21), caractérise par le fait qu'une résistance électrique (5) est installée à proximité du panneau de détection (4) de telle sorte que l'interrupteur de proximité répond en outre à des variations thermiques dans le panneau de détection.

**Claim**

A proximity switch (23) which responds to thermal changes in a detection field (4) accessible to radiation from outside the switch, and has an extension unit input (25) for connecting an actuating device (21),
characterised in that arranged between the extension unit input (25) and the zero potential there is an electric resistor (5) on the detection field (4), so that the proximity switch responds further to other thermal changes in the detector field.

FIG 1

FIG 2